# EUROPEAN PATENT APPLICATION

(11) **EP 4 475 197 A1**
(43) Date of publication of application: **11.12.2024**
(21) Application number: 23887184.2
(22) Date of filing: 14.07.2023
(51) Int. Cl.: H01L 31/18

(54) **IBC BATTERY AND MANUFACTURING METHOD THEREFOR**

(30) Priority: 26.04.2023 CN 202310460134
(71) Applicant: Hengdian Group DMEGC Magnetics Co., Ltd, Jinhua, Zhejiang 322118 (CN)
(72) Inventor: The designation of the inventor has not yet been filed
(74) Representative: HGF
(86) International application number: PCT/CN2023/107435
(87) International publication number: WO 2024/221612

(57) **Abstract**

Disclosed are an IBC cell and a preparation method therefor. The preparation method comprises the following steps: (1) subjecting a raw silicon wafer to a texturing treatment, coating a protective layer, and subjecting the protective layer to an etching modification treatment; (2) subjecting the modified silicon wafer to a polishing treatment, and subjecting the polished silicon wafer to LPCVD for growing a TOPCon cell structure, and then performing laser ablation; and (3) cleaning a polycrystalline silicon layer and the protective layer of the silicon wafer after the laser ablation, preparing a passivation layer, and then performing metallization to obtain the IBC cell. In the present application, aimed at the matter of the front-texturing and back-polishing of silicon wafers ignored in related art, a protective layer is provided in the preparation process of the IBC cell, simultaneously meeting the needs of the front textured surface and the back polished surface.

## Description

### TECHNICAL FIELD

Examples of the present application relate to the technical field of solar cells, for example, an IBC cell and a preparation method therefor.

### BACKGROUND

Because the IBC cell does not have busbars on the front, and the positive electrode and negative electrode are on the back of the cell, there is no need to consider the front metal contact, so that the cell is optimized to the maximum extent possible. N-type silicon wafers have received great attention from the photovoltaic industry due to their advantages such as little light-induced degradation and long minority carrier lifetime. However, compared with P-type silicon wafers, N-type silicon wafers also have a certain price disadvantage, and meanwhile considering the fact that most cell manufacturers still mainly focus on the P-type PERC, so in order to extend the factory lifetime, P-type IBC has also received a lot of attention.

From the perspective of the polished surface and textured surface, the control ability of the polished surface to interface recombination is stronger, and at the same time, there is a greater possibility of total reflection for the polished surface when exposed to light with various wavelengths, especially long wavelengths, so the polished surface is the first choice for the back side of the cell. The pyramidal textured surface is an inevitable choice for the front side of the cell due to the need of light trapping.

CN108447947A discloses a preparation method for a passivated contact IBC cell. The preparation method comprises: growing a back surface oxide layer on the back surface of an N-type crystalline silicon substrate, then growing an intrinsic polycrystalline silicon layer or an intrinsic amorphous silicon layer on the back surface oxide layer, and then injecting boron ions onto the intrinsic polycrystalline silicon layer or the intrinsic amorphous silicon layer; then growing a mask, performing laser grooving to form a p+ area and a n+ area which are crossed, and finally annealing the p+ area and doping the n+ area with phosphorus diffusion at one time, so that a doped area at which p+ and n+ are alternated is formed on the back. The beneficial effects are: the oxide layer can give a better surface passivation effect to the back surface of the N-type crystalline silicon substrate, and meanwhile, the carriers can be freely transported through the oxide layer, so that the prepared cell has a higher open-circuit voltage and conversion efficiency; the n+ doped area on the back surface and the p+ doped area on the back surface are formed together in one high-temperature process, which greatly reduces the number of high-temperature processes and saves the production cost. However, this method does not pay attention to the front-texturing and back-polishing of silicon wafers, and ignores the difficulty of preparing this structure.

### SUMMARY

The following is a summary of the subject described in detail herein. This summary is not intended to limit the protection scope of the claims.

Examples of the present application provide an IBC cell and a preparation method therefor. In the present application, aimed at the matter of the front-texturing and back-polishing of silicon wafers ignored in related art, a protective layer is provided in the preparation process of the IBC cell, simultaneously meeting the needs of the front textured surface and the back polished surface.

In a first aspect, an example of the present application provides a preparation method for an IBC cell, and the preparation method comprises the following steps:
(1) subjecting a raw silicon wafer to a texturing treatment, coating a protective layer, and subjecting the protective layer to an etching modification treatment;
(2) subjecting the silicon wafer modified to a polishing treatment, and subjecting the silicon wafer polished to LPCVD for growing a TOPCon cell structure, and then performing laser ablation; and
(3) cleaning a polycrystalline silicon layer and the protective layer of the silicon wafer after the laser ablation, preparing a passivation layer, and then performing metallization to obtain the IBC cell.

In the present application, after the silicon wafer is textured, a protective material with a certain thickness is used to protect the silicon wafer, and the use of the protective layer not only avoids the back-polishing damaging the front-side textured surface, which provides the best process for the front light-trapping, but also prevents phosphorus in the polycrystalline silicon layer from doping inwards and forming a recombination center.

In the present application, the formation of P region does not need the doping of boron, and the protective layer is used to protect the textured surface on the front to have the lowest possible reflectivity so as to increase a short-circuit current; meanwhile, the laser ablation area is in a polished state, so that the long-wavelength light transmitted into the cell is reflected to the maximum, which is conducive to forming more carrier-excitation, thereby improving the conversion efficiency of the cell.

Preferably, the texturing treatment in step (1) is performed at a temperature of 75-82 °C, such as 75 °C, 76 °C, 78 °C, 80 °C, or 82 °C.

Preferably, the texturing treatment is performed for a period of 400-600 s, such as 400 s, 450 s, 500 s, 550 s, or 600 s.

Preferably, before the texturing treatment, pre-alkali washing is performed.

Preferably, an alkaline solution of the texturing treatment comprises sodium hydroxide and an additive.

Preferably, in the alkaline solution, the sodium hydroxide has a mass concentration of 1.5-5%, such as 1.5%, 2%, 3%, 4%, or 5%.

Preferably, in the alkaline solution, the additive has a mass concentration of 0.3-1.5%, such as 0.3%, 0.5%, 0.8%, 1%, or 1.5%.

Preferably, after the texturing treatment, post-alkali washing, acid pickling, slow-lifting, and a drying treatment are performed.

Preferably, a material of the protective layer in step (1) comprises silicon nitride.

Preferably, the protective layer has a thickness of 60-200 nm, such as 60 nm, 80 nm, 100 nm, 150 nm, or 200 nm, etc.

However, the thickness of the protective layer will affect the performance of the IBC cell, and if the thickness exceeds the above range, the stress generated accordingly will result in warpage of the silicon wafer, affecting the process automation.

Preferably, the modification treatment in step (1) comprises an etching treatment.

Preferably, an etching solution used in the etching treatment comprises hydrofluoric acid.

Preferably, the hydrofluoric acid has a concentration of 75-85%, such as 75%, 78%, 80%, 82%, or 85%.

Preferably, the modification treatment is performed for a period of 30-60 s, such as 30 s, 35 s, 40 s, 50 s, or 60 s.

Preferably, the polishing treatment in step (2) is performed at a temperature of 68-75 °C, such as 68 °C, 69 °C, 70 °C, 72 °C, or 75 °C.

Preferably, the polishing treatment is performed for a period of 200-300 s, such as 200 s, 220 s, 250 s, 280 s, or 300 s.

Preferably, in an alkaline solution used in the polishing treatment, sodium hydroxide has a mass concentration of 1.5-5%, such as 1.5%, 2%, 3%, 4%, or 5%.

Preferably, in the alkaline solution, an additive has a mass concentration of 0.9-1.4%, such as 0.9%, 1%, 1.1%, 1.2%, or 1.4%.

Preferably, after the polishing treatment, alkali washing, acid pickling, slow-lifting, and a drying treatment are performed.

Preferably, for the growth of the TOPCon cell structure in step (2), a tunnel layer has a thickness of 1.2-1.8 nm, such as 1.2 nm, 1.4 nm, 1.5 nm, 1.6 nm, or 1.8 nm.

Preferably, for the growth of the TOPCon cell structure, a polycrystalline silicon layer has a thickness of 80-180 nm, such as 80 nm, 100 nm, 120 nm, 150 nm, or 180 nm.

Preferably, for the growth of the TOPCon cell structure, a phosphorus concentration is 1e²⁰-4e²¹/cm³, such as 1e²⁰/cm³, 2e²⁰/cm³, 3e²¹/cm³, or 4e²¹/cm³.

Preferably, the laser ablation in step (2) is performed at a power of 20-40 W, such as 20 W, 25 W, 30 W, 35 W, or 40 W.

Preferably, the laser ablation is performed at a frequency of 400-800 kHz, such as 400 kHz, 500 kHz, 600 kHz, 700 kHz, or 800 kHz.

Preferably, the laser ablation is performed with a busbar width of 800-1000 µm, such as 800 µm, 850 µm, 900 µm, 950 µm, or 1000 µm.

Preferably, the laser ablation is performed with a busbar spacing of 15-20 mm, such as 15 mm, 16 mm, 17 mm, 18 mm, 19 mm, or 20 mm.

Preferably, the laser ablation is performed with a finger width of 180-250 µm, such as 180 µm, 190 µm, 200 µm, 220 µm, or 250 µm.

Preferably, the laser ablation is performed with a finger spacing of 1.1-1.5 mm, such as 1.1 mm, 1.2 mm, 1.3 mm, 1.4 mm, or 1.5 mm.

Preferably, the polycrystalline silicon layer in step (3) is cleaned at a temperature of 70-85 °C, such as 70 °C, 72 °C, 75 °C, 80 °C, or 85 °C.

Preferably, the polycrystalline silicon layer is cleaned for a period of 300-450 s, such as 300 s, 320 s, 350 s, 400 s, or 450 s.

Preferably, in a cleaning solution for the polycrystalline silicon layer, NaOH has a concentration of 1.5-5%, such as 1.5%, 2%, 3%, 4%, or 5%.

Preferably, in the cleaning solution for the polycrystalline silicon layer, an additive has a concentration of 0.5-2.5%, such as 0.5%, 1%, 1.5%, 2%, or 2.5%, etc.

Preferably, in a cleaning solution for the protective layer, HF has a concentration of 8-20%, such as 8%, 10%, 12%, 15%, or 20%.

Preferably, in the cleaning solution for the protective layer, HCl has a concentration of 4.5-10%, such as 4.5%, 5%, 6%, 8%, or 10%.

Preferably, the protective layer is cleaned for a period of 150-300 s, such as 150 s, 180 s, 200 s, 250 s, or 300 s.

Preferably, the passivation layer in step (3) comprises an aluminum oxide layer and a silicon nitride layer.

Preferably, the aluminum oxide layer has a thickness of 2-10 nm, such as 2 nm, 4 nm, 6 nm, 8 nm, or 10 nm.

Preferably, the silicon nitride layer has a thickness of 60-180 nm, such as 60 nm, 80 nm, 100 nm, 150 nm, or 180 nm.

Preferably, in the metallization, a laser off/on ratio is (0.5-0.8):0.3, such as 0.5:0.3, 0.6:0.3, 0.7:0.3, or 0.8:0.3.

Preferably, in the metallization, a silver grid line has an aspect ratio of 1:(3-6), such as 1:3, 1:4, 1:5, or 1:6.

Preferably, in the metallization, an aluminum grid line has an aspect ratio of 1 :(5-7), such as 1:5, 1:5.5, 1:6, 1:6.5, or 1:7.

Preferably, in the metallization, a silver paste has a total wet weight of 120-170 g, such as 120 g, 130 g, 140 g, 150 g, 160 g, or 170 g.

Preferably, in the metallization, an aluminum paste has a total wet weight of 120-150 g, such as 120 g, 130 g, 140 g, or 150 g.

In the second aspect, an example of the present application provides an IBC cell, and the IBC cell is prepared by the method according to the first aspect.

Compared with the related art, the examples of the present application have the following beneficial effects.
(1) In the examples of the present application, the formation of a structure where the front has a textured surface and the back laser area has a polished surface is ensured so as to more effectively use long-wavelength light and increase the number of excited carriers, thereby improving the conversion efficiency of solar cells.
(2) In the examples of the present application, for the IBC cell, an efficiency can reach more than or equal to 23.69%, and a short-circuit current can reach more than or equal to 13.639 A.

After the accompanying drawings and detailed description are read and understood, other aspects can be understood.

### BRIEF DESCRIPTION OF DRAWINGS

Accompanying drawings are used to provide a further understanding of the technical solutions herein, and form part of the specification, explain the technical solutions together with examples of the present application, and do not limit the technical solutions herein.
FIG. 1 is a preparation flow chart of the IBC cell in Example 1 of the present application.
FIG. 2 is a preparation schematic diagram of the IBC cell in Example 1 of the present application.
FIG. 3 is a structural schematic diagram of the IBC cell in Example 1 of the present application; reference list: 1-silicon substrate; 2-oxide layer; 3-p-type/n-type polycrystalline silicon layer; 4-aluminum oxide; 5-silicon nitride; 6-silver electrode; and 7-aluminum electrode.
FIG. 4 shows a pattern of the IBC cell in Example 1 of the present application; reference list: 3-p-type/n-type polycrystalline silicon layer; 6-silver electrode; and 7-aluminum electrode.

### DETAILED DESCRIPTION

The technical solutions of the present application are further explained by the embodiments below. Those skilled in the field should understand that the examples merely assist in understanding the present application and should not be regarded as a specific limitation to the present application.

### Example 1

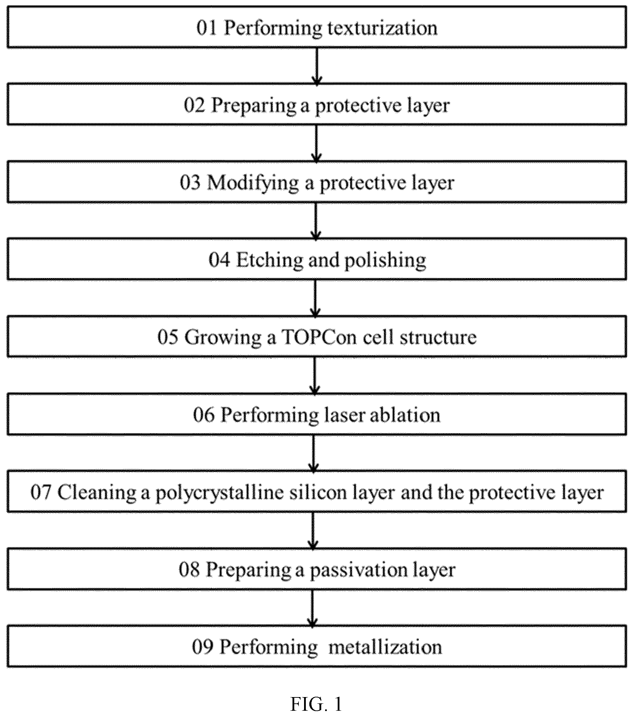

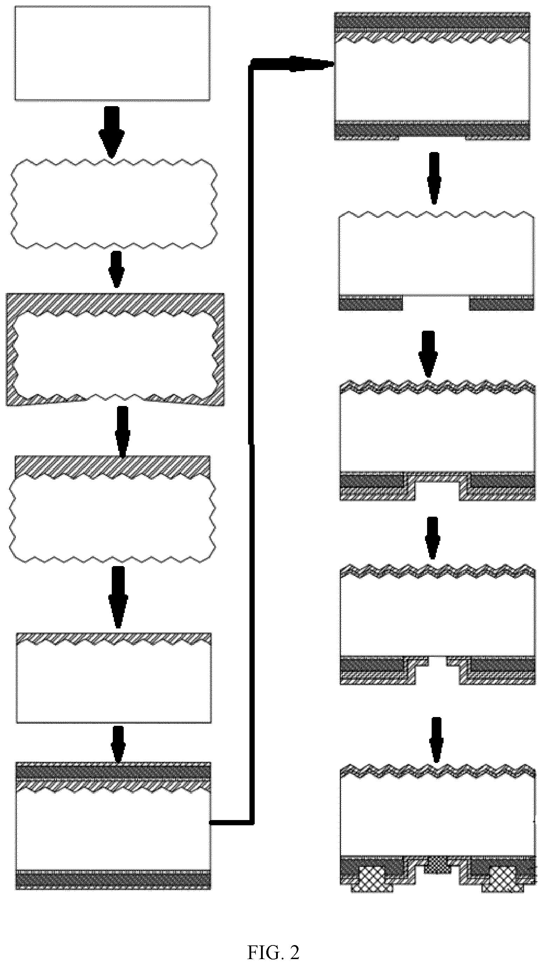

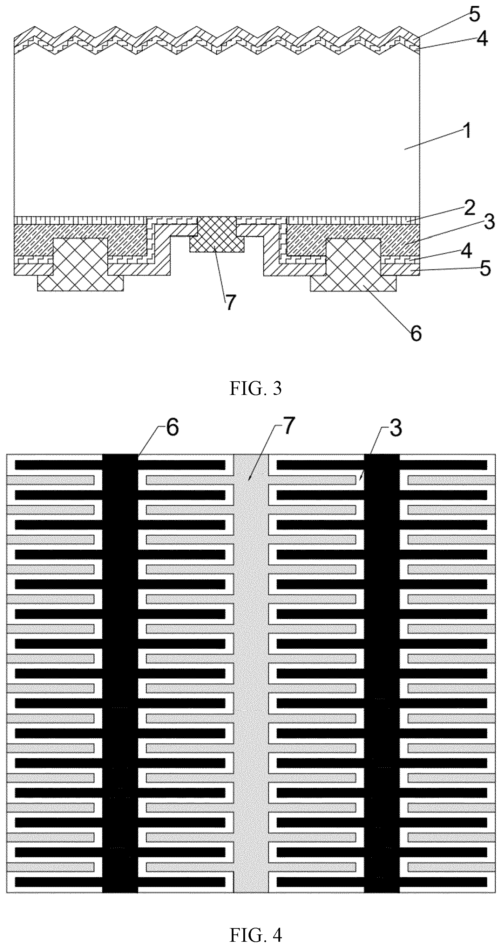

This example provides an IBC cell, and the preparation flowchart of the IBC cell is shown in FIG. 1, and the preparation schematic diagram of the IBC cell is shown in FIG. 2, and a preparation method for the IBC cell is as follows:
(1) a raw silicon wafer was put into a texturing machine, and subjected to pre-alkali washing, then texturing, where the texturing was performed at a temperature of 82 °C for a period of 600 s, NaOH had a concentration of 5%, and an additive had a concentration of 0.3%; and then post-alkali washing, acid pickling, slow-lifting, and drying, and the textured silicon wafer was coated with a protective layer with a thickness of 200 nm; the silicon wafer coated with a protective layer was put into an inline etching machine, where HF had a concentration of 85% and the reaction was performed for 60 s;
(2) the etched silicon wafer was put into a polishing machine, and subjected to pre-alkali washing and then polishing where the polishing was performed at a temperature of 75 °C for a period of 300 s, NaOH had a concentration of 5%, and an additive had a concentration of 0.9%; then post-alkali washing, acid pickling, slow-lifting, and drying were performed, and the polished silicon wafer was subjected to LPCVD for growing a TOPCon cell structure, where a grown tunnel layer had a thickness of 1.8 nm, a polycrystalline silicon layer had a thickness of 180 nm, and a phosphorus concentration was 4e²¹/cm³; the silicon wafer after the growth of the TOPCon cell structure was subjected to laser ablation where laser had a rated power of 40 W and a frequency of 400 KHz, a busbar had a width of 1000 µm and a spacing of 20 mm, and a finger had a width of 250 µm and a spacing of 1.5 mm; and
(3) the polycrystalline silicon layer and the protective layer of the silicon wafer after the laser ablation were cleaned; the silicon wafer after the laser ablation was put into an etching machine, a front PSG was cleaned, and then the polycrystalline silicon layer was cleaned, where the reaction was performed at a temperature of 85 °C for a period of 450 s, NaOH had a concentration of 5%, and an additive had a concentration of 0.5%; then post-alkali washing was performed to clean the protective layer where a concentration of HF was 20%, a concentration of HCl was 10%, and the reaction was performed for 300 s; the cleaned silicon wafer was sequentially subjected to NCD and PECVD for growing aluminum oxide with a thickness of 10 nm and silicon nitride with a thickness of 180 nm; metallization was performed, where the laser had an off/on ratio of 0.8:0.3, a silver grid line had an aspect ratio of 1:6, an aluminum grid line had an aspect ratio of 1:7, a silver paste had a total wet weight of 170 g, and an aluminum paste had a total wet weight of 150 g, and the IBC cell was obtained; the structural schematic diagram of the IBC cell is shown in FIG. 3, and the pattern of the IBC cell is shown in FIG. 4.

### Example 2

This example provides an IBC cell, and a preparation method for the IBC cell is as follows:
(1) a raw silicon wafer was put into a texturing machine, and subjected to pre-alkali washing, then texturing, where the texturing was performed at a temperature of 75 °C for a period of 400 s, NaOH had a concentration of 1.5%, and an additive had a concentration of 1.5%, and then post-alkali washing, acid pickling, slow-lifting, and drying, and the textured silicon wafer was coated with a protective layer with a thickness of 60 nm by double-insertion; the silicon wafer coated with a protective layer was put into an inline etching machine, where HF had a concentration of 75% and the reaction was performed for 30 s;
(2) the etched silicon wafer was put into a polishing machine, and subjected to pre-alkali washing and then polishing where the polishing was performed at a temperature of 68 °C for a period of 200 s, NaOH had a concentration of 1.5%, and an additive had a concentration of 1.4%; then post-alkali washing, acid pickling, slow-lifting, and drying were performed, and the polished silicon wafer was subjected to LPCVD for growing a TOPCon cell structure, where a grown tunnel layer had a thickness of 1.2 nm, a polycrystalline silicon layer had a thickness of 80 nm, and a phosphorus concentration was 1e²⁰/cm³; the silicon wafer after the growth of the TOPCon cell structure was subjected to laser ablation where laser had a rated power of 20 W and a frequency of 800 KHz, a busbar had a width of 800 µm and a spacing of 15 mm, and a finger had a width of 180 µm and a spacing of 1.1 mm; and
(3) the polycrystalline silicon layer and the protective layer of the silicon wafer after the laser ablation were cleaned; the silicon wafer after the laser ablation was put into an etching machine, a front PSG was cleaned, and then the polycrystalline silicon layer was cleaned, where the reaction was performed at a temperature of 70 °C for a period of 300 s, NaOH had a concentration of 1.5%, and an additive had a concentration of 2.5%; then post-alkali washing was performed to clean the protective layer where a concentration of HF was 8%, a concentration of HCl was 4.5%, and the reaction was performed for 150 s; the cleaned silicon wafer was sequentially subjected to NCD and PECVD for growing aluminum oxide with a thickness of 2 nm and silicon nitride with a thickness of 60 nm; metallization was performed, where the laser had an off/on ratio of 0.5:0.3, a silver grid line had an aspect ratio of 1:3, an aluminum grid line had an aspect ratio of 1:5, a silver paste had a total wet weight of 120 g, and an aluminum paste had a total wet weight of 120 g, and the IBC cell was obtained.

### Example 3

This example provides an IBC cell, and a preparation method for the IBC cell is as follows:
(1) a raw silicon wafer was put into a texturing machine, and subjected to pre-alkali washing and then texturing, where the texturing was performed at a temperature of 78 °C for a period of 500 s, NaOH had a concentration of 3.0%, and an additive had a concentration of 1.0%; and then post-alkali washing, acid pickling, slow-lifting, and drying were performed, the textured silicon wafer was coated a protective layer with a thickness of 120 nm by double-insertion; the silicon wafer coated with a protective layer was put into an inline etching machine where HF had a concentration of 80% and the reaction was performed for 45 s;
(2) the etched silicon wafer was put into a polishing machine, and subjected to pre-alkali washing and then polishing where the polishing was performed at a temperature of 72 °C for a period of 250 s, NaOH had a concentration of 3.5%, and an additive had a concentration of 1.1%; then post-alkali washing, acid pickling, slow-lifting, and drying were performed, and the polished silicon wafer was subjected to LPCVD for growing a TOPCon cell structure, where a grown tunnel layer had a thickness of 1.5 nm, a polycrystalline silicon layer had a thickness of 120 nm, and a phosphorus concentration was 6 e²⁰/cm³; the silicon wafer after the growth of the TOPCon cell structure was subjected to laser ablation where laser had a rated power of 30 W and a frequency of 600 KHz, a busbar had a width of 900 µm and a spacing of 18 mm, and a finger had a width of 220 µm and a spacing of 1.3 mm; and
(3) the polycrystalline silicon layer and the protective layer of the silicon wafer after the laser ablation were cleaned; the silicon wafer after the laser ablation was put into an etching machine, a front PSG was cleaned, and then the polycrystalline silicon layer was cleaned, where the reaction was performed at a temperature of 75 °C for a period of 360 s, NaOH had a concentration of 3.5%, and an additive had a concentration of 1.5%; then post-alkali washing was performed to clean the protective layer where a concentration of HF was 15%, a concentration of HCl was 7.5%, and the reaction was performed for 220 s; the cleaned silicon wafer was sequentially subjected to NCD and PECVD for growing aluminum oxide with a thickness of 6 nm and silicon nitride with a thickness of 120 nm; metallization was performed, where the laser had an off/on ratio of 0.6:0.3, a silver grid line had an aspect ratio of 1:4.5, an aluminum grid line had an aspect ratio of 1:6, a silver paste had a total wet weight of 140 g, an aluminum paste had a total wet weight of 135 g, and an aluminum paste had a total wet weight of 120 g, and the IBC cell was obtained.

### Comparative Example 1

This comparative example provides an IBC cell, and a preparation method for the IBC cell is as follows:
(1) a raw silicon wafer was put into a texturing machine, and subjected to pre-alkali washing and then texturing where the texturing was performed at a temperature of 82 °C for a period of 600 s, NaOH had a concentration of 5%, and an additive had a concentration of 0.3%, and then post-alkali washing, acid pickling, slow-lifting, and drying were performed;
(2) the textured silicon wafer was subjected to LPCVD for growing a TOPCon cell structure, where a grown tunnel layer had a thickness of 1.8 nm, a polycrystalline silicon layer had a thickness of 180 nm, and a phosphorus concentration was 4 e²¹/cm³, the silicon wafer after the growth of the TOPCon cell structure was subjected to laser ablation where laser had a rated power of 40 W and a frequency of 400 KHz, a busbar had a width of 1000 µm and a spacing of 20 mm, and a finger had a width of 250 µm and a spacing of 1.5mm; and
(3) the polycrystalline layer and the protective layer of the silicon wafer after the laser ablation were cleaned; the silicon wafer after the laser ablation was put into an etching machine, a front PSG was cleaned, and then the polycrystalline silicon layer was cleaned, where the reaction was performed at a temperature of 85 °C for a period of 450 s, NaOH had a concentration of 5%, and an additive had a concentration of 0.5%; then post-alkali washing was performed to clean the protective layer where a concentration of HF was 20%, a concentration of HCl was 10%, and the reaction was performed for 300 s; the cleaned silicon wafer was sequentially subjected to NCD and PECVD for growing aluminum oxide with a thickness of 10 nm and silicon nitride with a thickness of 180 nm; metallization was performed, where the laser had an off/on ratio of 0.8:0.3, a silver grid line had an aspect ratio of 1:6, an aluminum grid line had an aspect ratio of 1:7, a silver paste had a total wet weight of 170 g, and an aluminum paste had a total wet weight of 150 g, and the IBC cell was obtained.

### Comparative Example 2

This comparative example provides an IBC cell, and a preparation method for the IBC cell is as follows:
(1) a raw silicon wafer was put into a texturing machine, and subjected to pre-alkali washing and then texturing where the texturing was performed at a temperature of 75 °C for a period of 400 s, NaOH had a concentration of 1.5%, and an additive had a concentration of 1.5%, and then post-alkali washing, acid pickling, slow-lifting, and drying were performed;
(2) the textured silicon wafer was subjected to LPCVD for growing a TOPCon cell structure, where a grown tunnel layer had a thickness of 1.2 nm, a polycrystalline silicon layer had a thickness of 80 nm, and a phosphorus concentration was 1e²⁰/cm³, the silicon wafer after the growth of the TOPCon cell structure was subjected to laser ablation where laser had a rated power of 20 W and a frequency of 800 KHz, a busbar had a width of 800 µm and a spacing of 15 mm, and a finger had a width of 180 µm and a spacing of 1.1 mm; and
(3) the polycrystalline layer and the protective layer of the silicon wafer after the laser ablation were cleaned; the silicon wafer after the laser ablation was put into an etching machine, a front PSG was cleaned, and then the polycrystalline silicon layer was cleaned, where the reaction was performed at a temperature of 70 °C for a period of 300 s, NaOH had a concentration of 1.5%, and an additive had a concentration of 2.5%; then post-alkali washing was performed to clean the protective layer where a concentration of HF was 8%, a concentration of HCl was 4.5%, and the reaction was performed for 150 s; the cleaned silicon wafer was sequentially subjected to NCD and PECVD for growing aluminum oxide with a thickness of 2 nm and silicon nitride with a thickness of 60 nm; metallization was performed, where the laser had an off/on ratio of 0.5:0.3, a silver grid line had an aspect ratio of 1:3, an aluminum grid line had an aspect ratio of 1:5, a silver paste had a total wet weight of 120 g, and an aluminum paste had a total wet weight of 120 g, and the IBC cell was obtained.

### Performance Testing

After the experiment of three batches, the efficiency (Eta), short-circuit current (Isc), open-circuit voltage (Uoc), and fill factor (FF) of the cells, the final product of the silicon wafers, were tracked, and the test results are shown in Table 1.

**Table 1**

| | Eta | Uoc (V) | Isc (A) | FF |
|---|---|---|---|---|
| Example 1 | 23.69 | 0.7049 | 13.639 | 81.35 |
| Example 2 | 23.71 | 0.7052 | 13.642 | 81.34 |
| Example 3 | 23.75 | 0.7056 | 13.649 | 81.42 |
| Comparative Example 1 | 23.53 | 0.7052 | 13.543 | 81.32 |
| Comparative Example 2 | 23.53 | 0.7053 | 13.544 | 81.31 |

As can be seen from Table 1, Examples 1-3 show that, for the IBC cell in the present application, the efficiency can reach more than or equal to 23.69%, and the short-circuit current can reach more than or equal to 13.639 A; the efficiency Eta is increased by 0.16-0.22% compared to that of comparative examples, and the main improvement lies in Isc, Uoc, and FF, especially the short-circuit current Isc which is increased by 96-106 mA.

The comparison of Example 1 with Comparative Examples 1 and 2 shows that in Example 1 the surface of the back laser-ablation area is polished with the addition of the protective film on the front, and in Comparative Examples 1 and 2, the laser ablation area has a textured surface, the difference of Uoc in Example 1 and Comparative Examples 1 and 2 is not significant, but Isc in Example 1 is 96 mA larger, which directly causes a difference of almost 0.16% in Eta.

Applicants declare that the above is only specific embodiments of the present application, but the protection scope of the present application is not limited thereto. Those skilled in the art should understand that any changes or replacements, which can be easily thought of by a person skilled in the art within the scope of the technology disclosed in the present application, shall fall within the protection scope and disclosure scope of the present application.

## Claims

1. A preparation method for an IBC cell, comprising the following steps:
(1) subjecting a raw silicon wafer to a texturing treatment, coating a protective layer, and subjecting the protective layer to an etching modification treatment;
(2) subjecting the silicon wafer modified to a polishing treatment, and subjecting the silicon wafer polished to LPCVD for growing a TOPCon cell structure, and then performing laser ablation; and
(3) cleaning a polycrystalline silicon layer and the protective layer of the silicon wafer after the laser ablation, preparing a passivation layer, and then performing metallization to obtain the IBC cell.

2. The preparation method according to claim 1, wherein the texturing treatment in step (1) is performed at a temperature of 75-82 °C.

3. The preparation method according to claim 1 or 2, wherein the texturing treatment is performed for a period of 400-600 s.

4. The preparation method according to any one of claims 1-3, wherein the preparation method comprises performing pre-alkali washing before the texturing treatment.

5. The preparation method according to any one of claims 1-4, wherein an alkaline solution of the texturing treatment comprises sodium hydroxide and an additive;
preferably, in the alkaline solution, the sodium hydroxide has a mass concentration of 1.5-5%;
preferably, in the alkaline solution, the additive has a mass concentration of 0.3-1.5%;
preferably, the preparation method comprises performing post-alkali washing, acid pickling, slow-lifting, and a drying treatment after the texturing treatment.

6. The preparation method according to any one of claims 1-5, wherein a material of the protective layer in step (1) comprises silicon nitride;
preferably, the protective layer has a thickness of 60-200 nm.

7. The preparation method according to any one of claims 1-6, wherein the modification treatment in step (1) comprises an etching treatment;
preferably, an etching solution used in the etching treatment comprises hydrofluoric acid;
preferably, the hydrofluoric acid has a concentration of 75-85%;
preferably, the modification treatment is performed for a period of 30-60 s.

8. The preparation method according to any one of claims 1-7, wherein the polishing treatment in step (2) is performed at a temperature of 68-75 °C;
preferably, the polishing treatment is performed for a period of 200-300 s;
preferably, an alkaline solution used in the polishing treatment contains sodium hydroxide by a mass concentration of 1.5-5%;
preferably, in the alkaline solution, an additive has a mass concentration of 0.9-1.4%;
preferably, the preparation method comprises performing alkali washing, acid pickling, slow-lifting, and a drying treatment after the polishing treatment.

9. The preparation method according to any one of claims 1-8, wherein for the growth of the TOPCon cell structure in step (2), a tunnel layer has a thickness of 1.2-1.8 nm;
preferably, for the growth of the TOPCon cell structure, a polycrystalline silicon layer has a thickness of 80-180 nm;
preferably, for the growth of the TOPCon cell structure, a phosphorus concentration is 1e²⁰-4e²¹/cm³.

10. The preparation method according to any one of claims 1-9, wherein the laser ablation in step (2) is performed at a power of 20-40 W;
preferably, the laser ablation is performed at a frequency of 400-800 kHz;
preferably, the laser ablation is performed with a busbar width of 800-1000 µm;
preferably, the laser ablation is performed with a busbar spacing of 15-20 mm;
preferably, the laser ablation is performed with a finger width of 180-250 µm;
preferably, the laser ablation is performed with a finger spacing of 1.1-1.5 mm.

11. The preparation method according to any one of claims 1-10, wherein the polycrystalline silicon layer in step (3) is cleaned at a temperature of 70-85 °C;
preferably, the polycrystalline silicon layer is cleaned for a period of 300-450 s;
preferably, in a cleaning solution for the polycrystalline silicon layer, NaOH has a concentration of 1.5-5%;
preferably, in the cleaning solution for the polycrystalline silicon layer, an additive has a concentration of 0.5-2.5%;
preferably, in a cleaning solution for the protective layer, HF has a concentration of 8-20%;
preferably, in the cleaning solution for the protective layer, HCl has a concentration of 4.5-10%;
preferably, the protective layer is cleaned for a period of 150-300 s.

12. The preparation method according to any one of claims 1-11, wherein the passivation layer in step (3) comprises an aluminum oxide layer and a silicon nitride layer;
preferably, the aluminum oxide layer has a thickness of 2-10 nm;
preferably, the silicon nitride layer has a thickness of 60-180 nm;
preferably, in the metallization, a laser off/on ratio is (0.5-0.8):0.3;
preferably, in the metallization, a silver grid line has an aspect ratio of 1: (3-6);
preferably, in the metallization, an aluminum grid line has an aspect ratio of 1: (5-7);
preferably, in the metallization, a silver paste has a total wet weight of 120-170 g;
preferably, in the metallization, an aluminum paste has a total wet weight of 120-150 g.

13. An IBC cell, which is prepared by the method according to any one of claims 1-12.
